# EUROPÄISCHE PATENTSCHRIFT

(11) **EP 1 114 435 B1**
(45) Veröffentlichungstag und Bekanntmachung des Hinweises auf die Patenterteilung: **05.06.2002**
(21) Anmeldenummer: 99971965.1
(22) Anmeldetag: 25.10.1999
(51) Int. Cl.: H01J 37/02, H01J 37/28

(54) **VERFAHREN ZUM UNTERSUCHEN UND/ODER ZUM MODIFIZIEREN VON OBERFLÄCHENSTRUKTUREN EINER PROBE**
METHOD FOR EXAMINING AND/OR MODIFYING SURFACE STRUCTURES OF A SAMPLE
PROCEDE POUR EXAMINER ET/OU MODIFIER DES STRUCTURES SUPERFICIELLES D'ECHANTILLONS

(30) Priorität: 09.11.1998 DE 19851622
(43) Veröffentlichungstag der Anmeldung: 11.07.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: BRÜNGER, Wilhelm, D-25524 Itzehoe (DE)
(74) Vertreter: Schoppe, Fritz, Dipl.-Ing.
(86) Internationale Anmeldenummer: EP9908057
(87) Internationale Veröffentlichungsnummer: WO0028571

(56) Entgegenhaltungen:
- EP-A- 0 969 494
- WO-A-98/32153
- DE-A- 3 332 248
- US-A- 5 591 970

## Beschreibung

Die vorliegende Erfindung bezieht sich auf ein Verfahren zum Untersuchen und/oder Modifizieren von Oberflächenstrukturen einer Probe mittels eines Strahls, der auf die Oberflächenstruktur der Probe auftrifft, bei dem zumindest im Auftreffbereichs des Strahls auf die Oberflächenstruktur der Probe Gas zugeführt wird.

Aus der Fachveröffentlichung W.H. Brünger und K.T. Kohlmann, "E-Beam Induced Fabrication of Microstructures", Micro Electro Mechanical Systems '92, erschienen im Zusammenhang mit der gleichnamigen Tagung in Travemünde, 4.- 7. Februar 1992, ist es bereits bekannt, Mikrostrukturen aufgrund eines elektronenstrahlinduzierten Herstellungsverfahrens zu erzeugen. Bei einem derartigen Verfahren bedient man sich typischerweise zur elektronenstrahlinduzierten Abscheidung eines modifizierten Abtastelektronenmikroskopes. In einer Kammer wird die zu bearbeitende Probe im Auftreffbereich des Elektronenstrahls angeordnet, wobei die Probe von einem metallorganischen Vorlaufgas umgeben ist, das beispielsweise bei einem Druck von 2 x 10⁻² mbar innerhalb einer Teilkammer gehalten wird. Der Elektronenstrahl tritt in die Teilkammer durch eine Öffnung ein, die den Grunddruck innerhalb des Mikroskopes bei 10⁻⁵ mbar hält.

Um eine erhöhte Abscheidungsrate bei dem Abscheidungsprozeß herbeizuführen, wird in dieser Schrift ferner vorgeschlagen, unter Verzicht auf eine Teilkammeranordnung das Vorlaufgas zur Auftreffstelle des Elektronenstrahls an der Probe kontinuierlich zuzuführen. In typischen Ausgestaltungen erfolgt die kontinuierliche Gaszufuhr über eine Gasdüse mit kleiner Öffnung von beispielsweise 100 Mikrometer, die sehr dicht an der Auftreffstelle des Elektronenstrahls positioniert ist.

Typische Abstände liegen zwischen 100 Mikrometer und 1 Milimeter. Dieses gezielte Begasen eines Oberflächenbereichs der Probe mit dem Präkursor-Gas anstelle des Flutens einer Teilkammer oder Objektkammer hat den Vorteil der geringeren Streuung des Strahls, wodurch das Auflösungsvermögen verbessert wird. Jedoch treffen auch bei dem gezielten kontinuierlichen Begasen mittels Gasdüse die Elektronen oder andere abbildende Teilchen des Strahls auf einem Teil ihres Weges auf Gasteilchen und werden gestreut.

Eine weitere Problematik des beschriebenen Abscheidungsverfahrens mittels örtlichen Begasens eines Oberflächenbereichs der Probe liegt darin, daß die Abscheidungsrate durch den Gasfluß begrenzt ist, der seinerseits durch den maximal zulässigen Kammerdruck des Systems und die Saugleistung des Pumpsystems eine obere Grenze hat.

Aus der Veröffentlichung D. Winkler, et al., "E-beam Probe station ...", Microelectronic Engineering 31 (1996), Seiten 141 - 147 ist bereits ein Verfahren zum elektronenstrahlinduzierten Ätzen von passivierten integrierten Schaltungen bekannt. Bei dem Verfahren wird Gas über eine Düse zum Auftreffbereich eines Elektronenstrahls an der zu ätzenden Oberflächenstruktur zugeführt. Hier erfolgt eine Adsorption von Ätzgasmolekülen auf der Oberfläche, wobei anschließend aufgrund der Wechselwirkung mit dem Ionenstrahl eine Dissoziation der Gasmoleküle erfolgt. Sodann bilden sich Produktmoleküle mit Substrat, woraufhin das Ätzprodukt desorbiert wird und von der Oberfläche entfernt wird. Auch bei der Produktbildung, Desorption und dem Entfernen des Ätzprodukts erfolgt eine Wechselwirkung mit dem Elektronenstrahl.

Auch hier erfolgt jedoch eine Streuung des Elektronenstrahls an den Gasteilchen, die örtlich über eine Düse zur Oberflächenstruktur der zu ätzenden Probe zugeführt werden.

Ausgehend von diesem Stand der Technik liegt der vorliegenden Erfindung die Aufgabe zugrunde, ein Verfahren zum Untersuchen oder zum Modifizieren von Oberflächenstrukturen einer Probe mittels eines Strahls so weiterzubilden, daß eine verbesserte Auflösung und/oder verbesserte Oberflächenmodifikationsgenauigkeit erreicht wird.

Diese Aufgabe wird durch ein Verfahren nach Anspruch 1 gelöst.

Der Erfindung liegt die Erkenntnis zugrunde, daß eine verbesserte Ortsauflösung bei den genannten Untersuchungsverfahren oder bei dem Verfahren zum Modifizieren von Oberflächenstrukturen mittels eines Strahls dann erreicht wird, wenn anstelle der kontinuierlichen Gaszuführung eine diskontinuierliche, vorzugsweise gepulste Gaszuführung eingesetzt wird.

Bei einem Ausführungsbeispiel der Erfindung wird zunächst ein Gasstoß mit erhöhtem Druck auf die Oberfläche der Probe abgegeben. Die Gasteilchen adsorbieren auf der Oberfläche und verweilen dort über eine gewisse Zeitdauer, die u.a. von der Gasart und der Oberflächentemperatur der Probe abhängt. Vorzugsweise wird man dem Partikelstrahl dann auf die Oberflächenstruktur der Probe auftreffen lassen, wenn nach Abschluß der gepulsten Gaszufuhr die Volumengasstöße bereits gering sind, jedoch die Oberflächengasstöße noch häufig sind, da dann die Partikel des Strahls die Oberfläche ungestreut erreichen und auf der Oberfläche chemische oder andere Reaktionen auslösen können.

Das Verfahren findet jedoch ebenfalls Anwendung bei der Untersuchung der Oberfläche einer Probe mittels einen Elektronenstrahls, wobei hier das diskontierlich zugeführte Gas dazu dient, eine elektrische Aufladung der Oberfläche der Probe abzubauen oder zu verhindern.

Ein bevorzugtes Ausführungsbeispiel der vorliegenden Erfindung wird nachfolgend unter Bezugnahme auf die beiliegenden Zeichnungen näher erläutert. Es zeigen:
- Figur 1:: Ein Rasterelektronenmikroskop zur Untersuchung einer Probe;
- Figur 2:: eine rasterelektronenmikroskopische Aufnahme einer keramischen Oberfläche mit Aufladungserscheinungen;
- Figur 3:: eine der Figur 2 entsprechende Aufnahme mit Ladungsneutralisation durch Gaseinlaß;
- Figur 4:: eine rasterelektronenmikroskopische Aufnahme mit Unterbrechung der Gaszufuhr während des Bilddurchlaufs des Rasterelektronenmikroskopes.

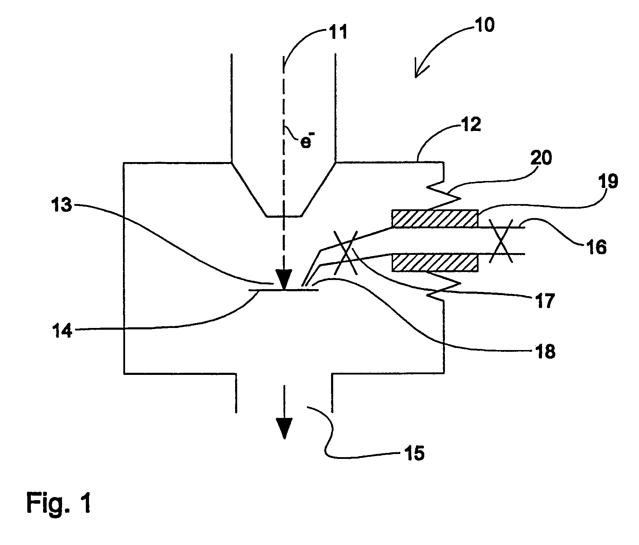

Wie in Figur 1 als schematische Querschnittsdarstellung gezeigt ist, umfaßt ein modifiziertes Abtastelektronenmikroskop, das in seiner Gesamtheit mit dem Bezugszeichen 10 bezeichnet ist, eine (nicht dargestellte) Elektronenstrahlkanone, die einen Elektronenstrahl 11 erzeugt, der bei einem Grunddruck von 10⁻⁵ mbar eine Kammer 12 durchläuft, um an einem Auftreffbereich 13 auf die Oberfläche einer Probe 14 aufzutreffen. Der genannten niedrige Innendruck der Kammer 12 wird durch ein (nicht dargestelltes) Pumpensystem bewerkstelligt, welches die Kammer 12 durch eine Absaugöffnung 15 evakuiert.

Prozeßgas wird der Kammer 12 über eine Zuleitung 16 zugeführt, welche zur Vermeidung nennenswerter Toträume direkt vor ihrer Ausströmdüse 18 mit einem Mikroventil 17 versehen ist. Die Lage der Ausstromdüse 18 gegenüber dem Auftreffbereich 13 der Probe 14 kann durch einen (nicht dargestellten) Manipulator eingestellt werden. Die Zuleitung 16 ist aus diesem Grunde über eine Dichtung 19 mit einem flexiblen Bereich 20 der Kammer 12 verbunden. Wie bereits erläutert, erfolgt die Gaszuführung durch Steuerung des Mikroventils 17 diskontinuierlich. Gemäß einem bevorzugten Ausführungsbeispiel erfolgt die diskontinuierliche Gaszuführung gepulst oder wird gezielt zeitlich gesteuert. In diesem Fall wird das Mikroventil derart angesteuert, daß die Schaltzeit bzw. Pulsdauer im Bereich von ca. 100µs bis bis einige Sekunden ist, z.B. 1 ms.

Das Abtasten der zu untersuchenden Oberfläche der Probe 14 durch den Elektronenstrahl 11 erfolgt nach einer Zeitspanne nach Beendigung des Gasstoßes, nach der die auf der Oberfläche adsorbierten Gasteilchen noch wirksam sind.

In Abhängigkeit von dem verwendeten Prozeßgas sowie dem verwendeten Strahl, der einen Ionenstrahl, Elektronenstrahl, Röntgenstrahl oder Laserstrahl sein kann, eignet sich die gezeigte Anordnung grundsätzlich auch zum partikelstrahlinduzierten Abscheiden von Materialien auf der Oberfläche der Probe oder zum Partikelstrahl-induzierten Ätzen.

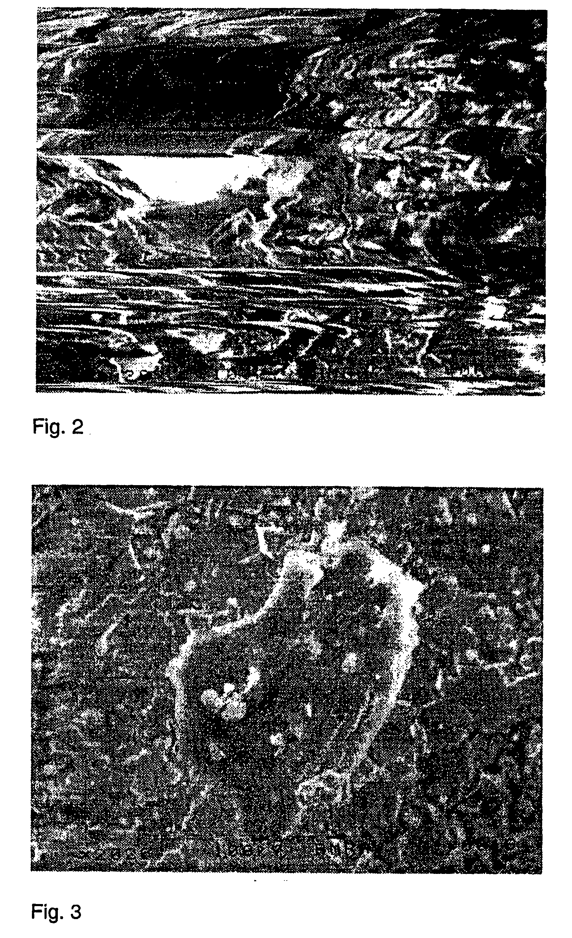

Figur 2 zeigt eine rasterelektronenmikroskopische Aufnahme einer keramischen Oberfläche während ihrer Abtastung durch den Rasterelektronenstrahl, ohne daß hierbei ein Gaseinlaß durch die Zuleitung 16 erfolgt, so daß es zu Aufladungserscheinungen an der keramischen Oberfläche kommt.

Figur 3 zeigt demgegenüber die rasterelektronenmikroskopische Aufnahme der gleichen keramischen Oberfläche, jedoch mit Ladungsneutralisation durch Zuleitung eines die Oberflächenladung neutralisierenden Gases.

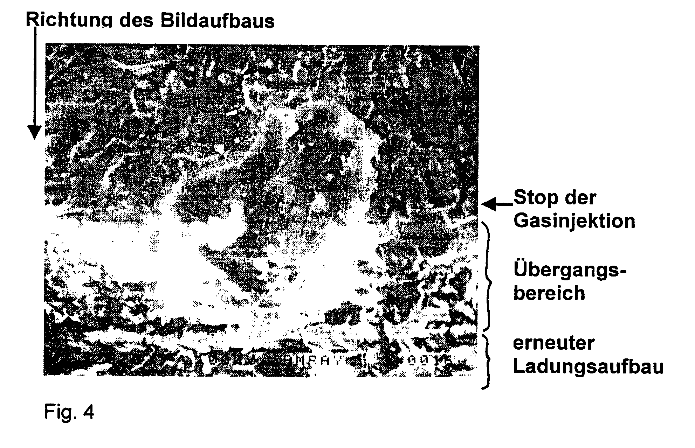

Figur 4 zeigt eine rasterelektronenmikroskopische Aufnahme, bei der während des Durchlaufs etwa in Höhe der Bildmitte die Gaszufuhr unterbrochen wird, so daß sich ab etwa der Hälfte des Bildes bis etwa 80 % in Richtung des Bildaufbaus ein störungsfreier Übergangsbereich ergibt, an den im hintersten (untersten) Fünftel des Bildes in Richtung des Bildaufbaus ein erneut gestörter Bereich durch erneuten Ladungsaufbau anschließt.

## Patentansprüche

1. Verfahren zum Untersuchen von Oberflächenstrukturen einer Probe und/oder zum Aufbringen oder Entfernen von Material auf oder von Oberflächenstrukturen einer Probe mittels eines Strahls, der auf die Oberflächenstruktur der Probe auftrifft, bei dem zumindest im Auftreffbereich des Strahls auf die Oberflächenstruktur der Probe Gas zugeführt wird,
**dadurch gekennzeichnet,**
**daß** das Gas diskontinuierlich zugeführt wird.

2. Verfahren nach Anspruch 1, **dadurch gekennzeichnet, daß** das Gas gepulst zugeführt wird.

3. Verfahren nach Anspruch 2, **dadurch gekennzeichnet, daß** die Pulsdauer kleiner ist als einige Sekunden.

4. Verfahren nach einem der Ansprüche 1 bis 3, bei dem die Oberfläche der Probe mittels eines Elektronenstrahls eines Elektronenmikroskopes untersucht wird,
bei dem das Gas eine elektrische Aufladung der Oberfläche der Probe vermindert.

5. Verfahren nach einem der Ansprüche 1 bis 3, bei dem die Oberfläche der Probe durch die Wirkung geladener Teilchen des Strahls auf an der Oberfläche der Probe adsorbierte Gase chemisch modifiziert wird.

6. Verfahren nach einem der Ansprüche 1 bis 5, bei dem der Strahl ein Elektronenstrahl ist.

7. Verfahren nach einem der Ansprüche 1 bis 5, bei dem der Strahl ein Ionenstrahl ist.

8. Verfahren nach einem der Ansprüche 1 bis 4, bei dem der Strahl ein Laserstrahl ist.

9. Verfahren nach einem der Ansprüche 1 bis 4, bei dem der Strahl ein Röntgenstrahl ist.

10. Verfahren nach Anspruch 5, bei dem das Gas ein für ein Strahl-induziertes Ätzen der Oberfläche der Probe geeignetes Prozeßgas ist.

11. Verfahren nach Anspruch 5, bei dem das Gas ein für ein Strahl-induziertes Abscheiden von Materialien auf der Oberfläche der Probe geeignetes Prozeßgas ist.

12. Verfahren nach Anspruch 4, bei dem zur Untersuchung biologischer Objekte das Gas derart gewählt wird, daß die biologischen Objekte bei ihrer Abbildung lebensfähig bleiben oder ihre Strukturen nur wenig geschädigt werden.

13. Verfahren nach Anspruch 12, bei dem das Gas H₂O ist.

14. Verfahren nach einem der Ansprüche 2 bis 13, bei dem der Strahl nur während solcher Zeitperioden auf die Oberflächenstruktur der Probe gerichtet wird, wenn nach Abschluß der gepulsten Gaszufuhr die auf der Oberfläche adsorbierten Gasteilchen noch wirksam sind.

## Claims

1. A method of examining surface structures of a sample and/or of applying or removing material to or from surface structures of a sample by means of a beam impinging on the surface structure of the sample, in the case of which gas is supplied at least in the area of impingement of the beam on the surface structure of the sample,
**characterized in that**
the gas is supplied discontinuously.

2. A method according to claim 1, **characterized in that** the gas is supplied in a pulsed mode.

3. A method according to claim 2, **characterized in that** the pulse duration is shorter than a few seconds.

4. A method according to one of the claims 1 to 3, wherein the surface of the sample is examined by means of an electron beam of an electron microscope, wherein the gas reduces the degree to which the surface of the sample is electrically charged.

5. A method according to one of the claims 1 to 3, wherein the surface of the sample is chemically modified by the effect of charged particles of the beam on gases adsorbed on the surface of the sample.

6. A method according to one of the claims 1 to 5, wherein the beam is an electron beam.

7. A method according to one of the claims 1 to 5, wherein the beam is an ion beam.

8. A method according to one of the claims 1 to 4, wherein the beam is a laser beam.

9. A method according to one of the claims 1 to 4, wherein the beam is an X-ray beam.

10. A method according to claim 5, wherein the gas is a process gas which is suitable for beam-induced etching of the surface of the sample.

11. A method according to claim 5, wherein the gas is a process gas which is suitable for beam-induced deposition of materials on the surface of the sample.

12. A method according to claim 4, wherein for the examination of biological objects the gas is chosen in such a way that, when imaged, said biological objects remain viable or that their structures are only affected to a minor extent.

13. A method according to claim 12, wherein the gas is H20.

14. A method according to one of the claims 2 to 13, wherein the beam is directed onto the surface structure of the sample only during periods of time in which the gas particles adsorbed on the surface are still effective after the termination of the pulsed supply of gas.

## Revendications

1. Procédé pour examiner des structures superficielles d'un échantillon et/ou pour appliquer ou éliminer de la matière sur ou de structures superficielles d'un échantillon à l'aide d'un faisceau tombant sur la structure superficielle de l'échantillon, dans lequel du gaz est alimenté au moins à la zone d'impact du faisceau sur la structure superficielle de l'échantillon, **caractérisé par le fait que** le gaz est alimenté de manière discontinue.

2. Procédé selon la revendication 1, **caractérisé par le fait que** le gaz est alimenté de manière pulsée.

3. Procédé selon la revendication 2, **caractérisé par le fait que** la durée de pulsation est inférieure à quelques secondes.

4. Procédé selon l'une des revendications 1 à 3, dans lequel la surface de l'échantillon est examinée à l'aide d'un faisceau électronique d'un microscope électronique,
dans lequel le gaz réduit une accumulation de charges électrostatiques à la surface de l'échantillon.

5. Procédé selon l'une des revendications 1 à 3, dans lequel la surface de l'échantillon est modifiée chimiquement par l'action de particules chargées du faisceau sur le gaz adsorbé à la surface de l'échantillon.

6. Procédé selon l'une des revendications 1 à 5, dans lequel le faisceau est un faisceau électronique.

7. Procédé selon l'une des revendications 1 à 5, dans lequel le faisceau est un faisceau ionique.

8. Procédé selon l'une des revendications 1 à 4, dans lequel le faisceau est un faisceau laser.

9. Procédé selon l'une des revendications 1 à 4, dans lequel le faisceau est un faisceau de rayons X.

10. Procédé selon la revendication 5, dans lequel le gaz est un gaz de procédé convenant pour la gravure induite par faisceau de la surface de l'échantillon.

11. Procédé selon la revendication 5, dans lequel le gaz est un gaz de procédé convenant pour le dépôt induit par faisceau de matières sur la surface de l'échantillon.

12. Procédé selon la revendication 4, dans lequel, pour l'examen d'objets biologiques, le gaz est choisi de sorte que les objets biologiques restent viables lors de leur reproduction en image ou que leurs structures ne soient que peu endommagées.

13. Procédé selon la revendication 12, dans lequel le gaz est de l'H₂O.

14. Procédé selon l'une des revendications 2 à 13, dans lequel le faisceau n'est orienté vers la structure superficielle que pendant les laps de temps pendant lesquels, à la fin de l'alimentation de gaz pulsée, les particules de gaz adsorbées à la surface sont encore actives.
